# EUROPEAN PATENT APPLICATION

(11) **EP 4 570 559 A1**
(43) Date of publication of application: **18.06.2025**
(21) Application number: 24218763.1
(22) Date of filing: 10.12.2024
(51) Int. Cl.: B60K 35/22, G02F 1/1333

(54) **DISPLAY DEVICE AND METHOD OF PRODUCING DISPLAY DEVICE**

(30) Priority: 14.12.2023 JP 2023211188
(71) Applicant: Alps Alpine Co., Ltd., Ota-ku, Tokyo 145-8501 (JP)
(72) Inventor: Komatsu, Masanori, Iwaki-city Fukushima (JP); Yamagata, Kazuyoshi, Iwaki-city Fukushima (JP); Yamashita, Daichi, Iwaki-city Fukushima (JP); Suzuki, Keiichiro, Iwaki-city Fukushima (JP); Haraguchi, Hiroki, Iwaki-city Fukushima (JP)
(74) Representative: Schmitt-Nilson Schraud Waibel Wohlfrom Patentanwälte Partnerschaft mbB

(57) **Abstract**

There is provided a display device that includes rear supports, a cover plate that is translucent and is fastened to a front of the rear supports, display panels disposed between the rear supports and the cover plate, and a resin connector. The rear supports are connected with one another via the resin connector. The cover plate covers the front of the rear supports, and is fastened to each of the rear supports. The display panels are disposed corresponding to the rear supports, respectively.

## Description

This patent application is based on and claims priority to Japanese Patent Application No. 2023-211188 filed on December 14, 2023.

The present disclosure relates to a display device including multiple display panels and a method of producing the display device.

An apparatus related to an in-vehicle display device is disclosed in JP 2021-138342 A. As illustrated in Fig. 1, a display unit of the in-vehicle display device is disposed inside a vehicle. The display unit includes multiple display panels, and a holder retaining the multiple display panels. It is disclosed in the paragraph [0024] that the holder includes multiple holding portions, and the multiple display panels are secured in the multiple holding portions, respectively, with an adhesive or screws, and the holder is formed of a resin material. Moreover, it is illustrated in Figs. 3 and 11 that the display unit has a shape in which the holder is curved.

The present disclosure relates to a display device and a method of producing a display device according to the appended claims. Embodiments are disclosed in the dependent claims. According to one aspect of the present disclosure, a display device includes rear supports, a cover plate that is translucent and is fastened to a front of the rear supports, display panels disposed between the rear supports and the cover plate, and a resin connector. The rear supports are connected with one another via the resin connector. The cover plate covers the front of the rear supports, and is fastened to each of the rear supports. The display panels are disposed corresponding to the rear supports, respectively.

Other objects and further features of the present disclosure will be apparent from the following detailed description when read in conjunction with the accompanying drawings, in which:

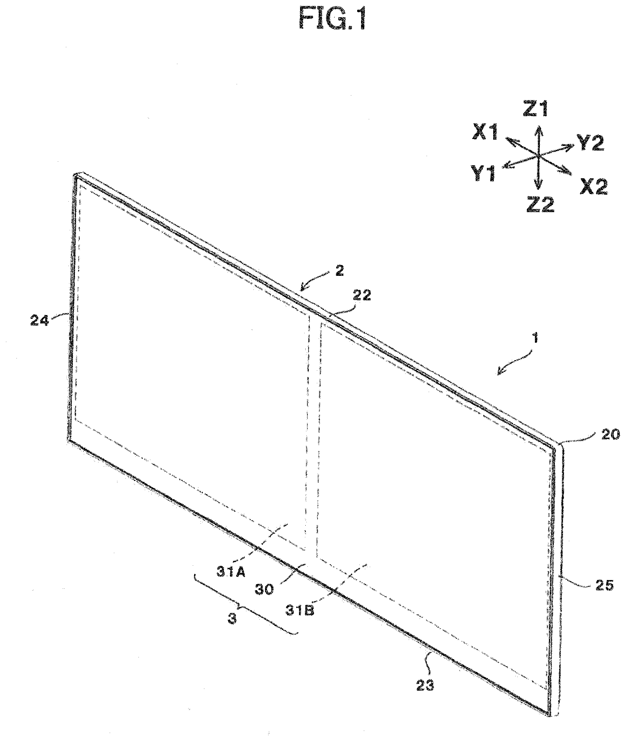

Fig. 1 is a perspective view illustrating a display device of a first embodiment of the present disclosure as viewed from the front;

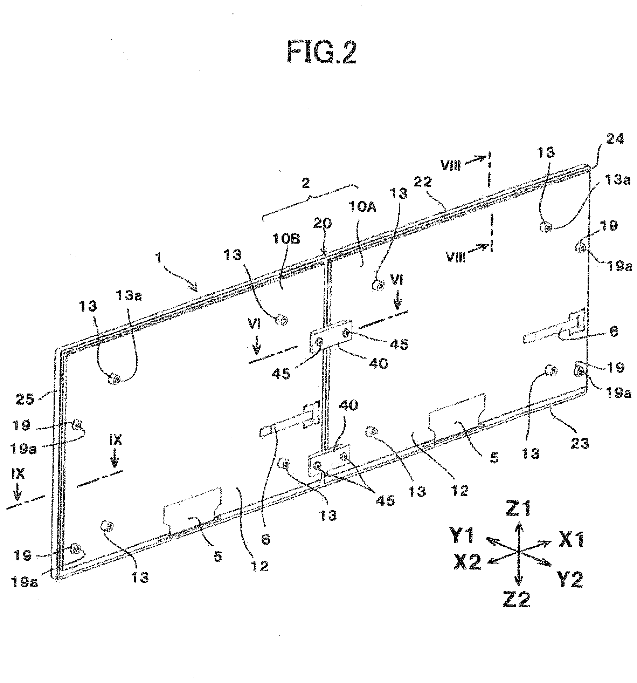

Fig. 2 is a perspective view illustrating the display device of the first embodiment of the present disclosure as viewed from the rear;

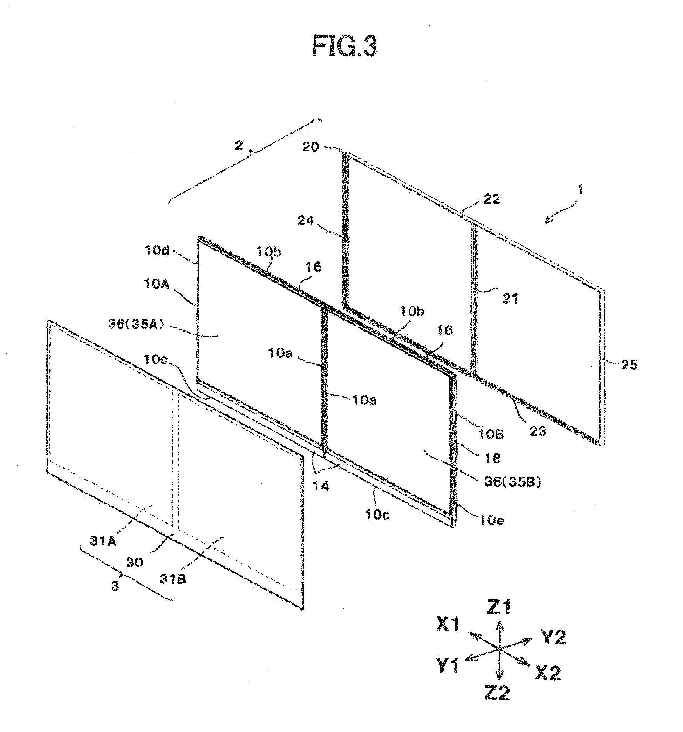

Fig. 3 is a display device illustrating the display device of the first embodiment of the present disclosure, in which constituent components are separated and viewed from the front;

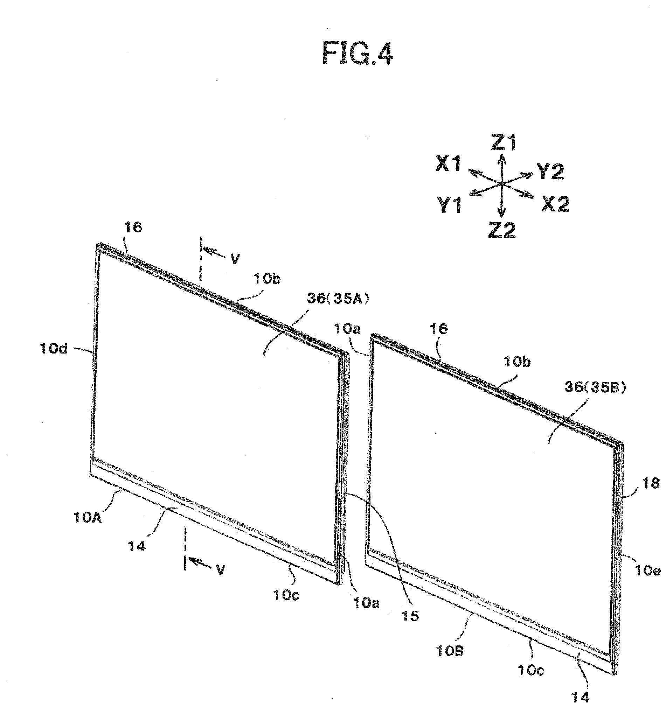

Fig. 4 is a perspective view illustrating two rear supports and backlight units respectively disposed in the rear supports, which constitute the display device of the first embodiment of the present disclosure, as viewed from the front;

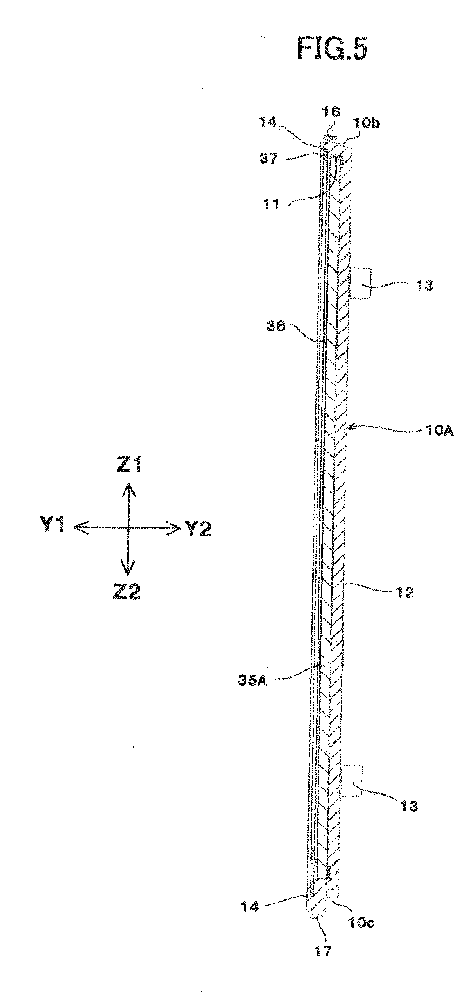

Fig. 5 is a cross-sectional view cutting the rear support and the backlight unit along the line V-V illustrated in Fig. 4;

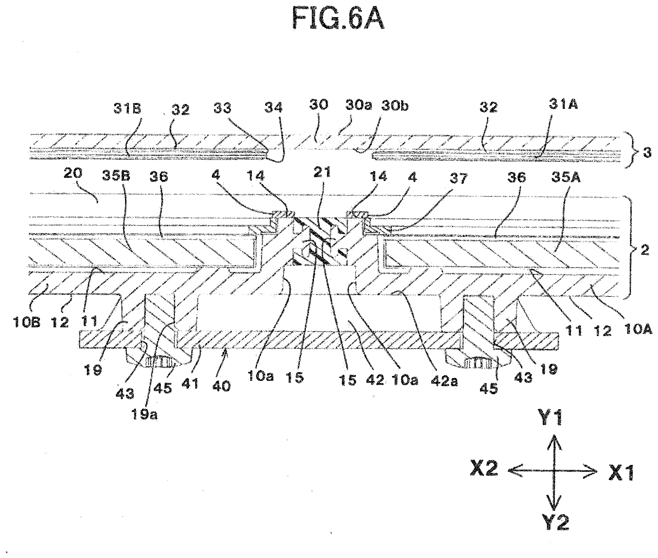

Fig. 6A is a partial cross-sectional view cutting the display device of the first embodiment of the present disclosure illustrated in Fig. 2 along the line VI-VI, and illustrating a state before the cover plate is bonded to the front of the rear supports;

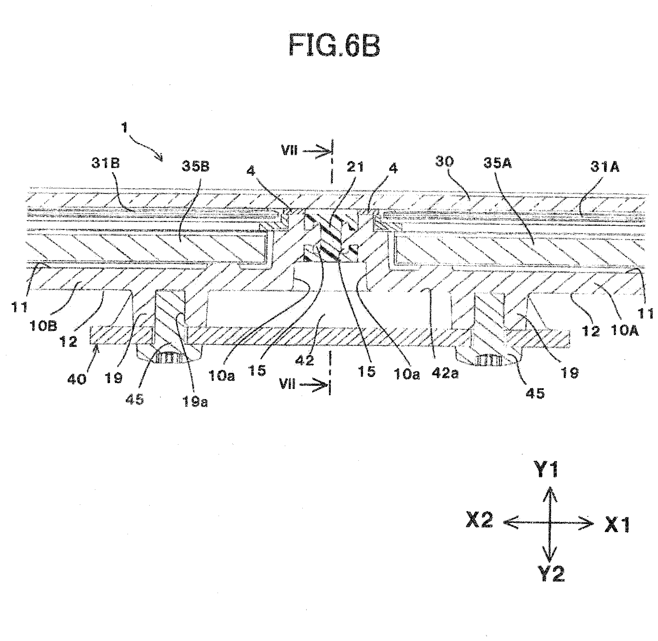

Fig. 6B is a partial cross-sectional view cutting the display device of the first embodiment of the present disclosure illustrated in Fig. 2 along the line VI-VI, and illustrating a state in which the cover plate is bonded to the front of the rear supports;

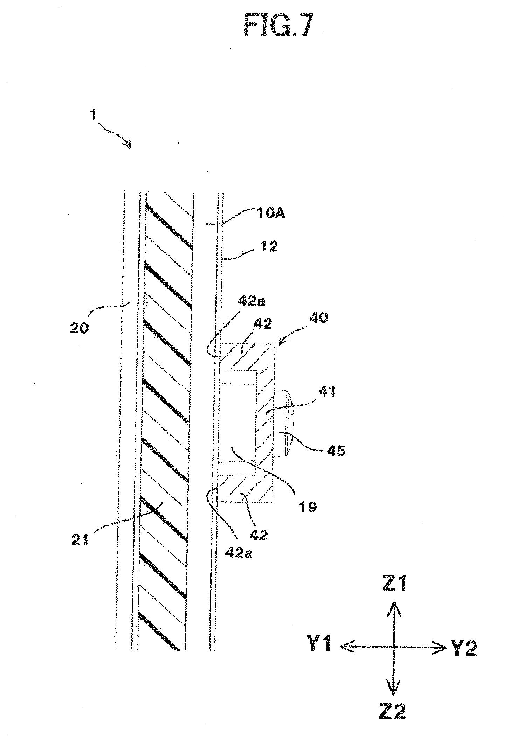

Fig. 7 is a partial cross-sectional view cutting the display device illustrated in Fig. 6B along the line VII-VII;

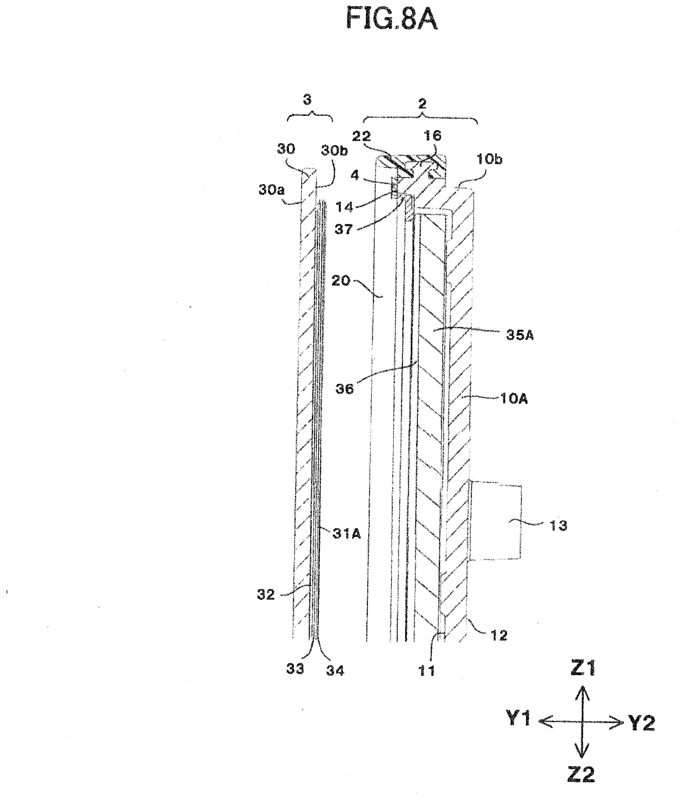

Fig. 8A is a partial cross-sectional view cutting the display device of the first embodiment of the present disclosure illustrated in Fig. 2 along the line VIII-VIII, and illustrating a state before the cover plate is bonded to the front of the rear support;

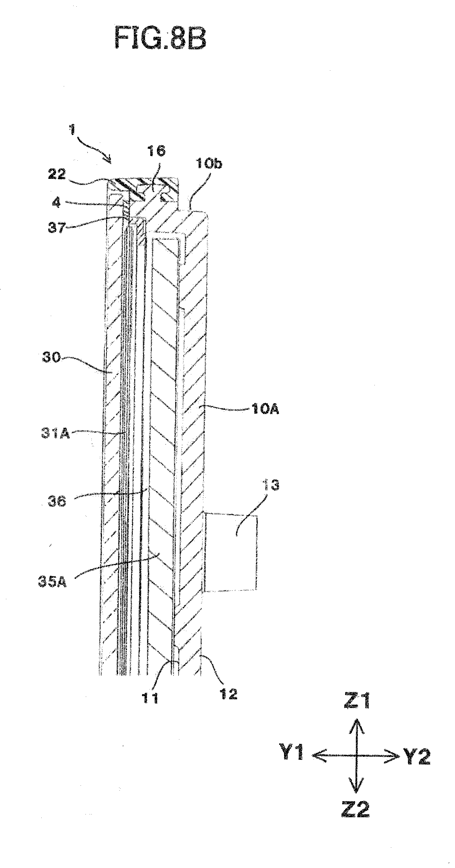

Fig. 8B is a partial cross-sectional view cutting the display device of the first embodiment of the present disclosure illustrated in Fig. 2 along the line VIII-VIII, and illustrating a state in which the cover plate is bonded to the front of the rear support;

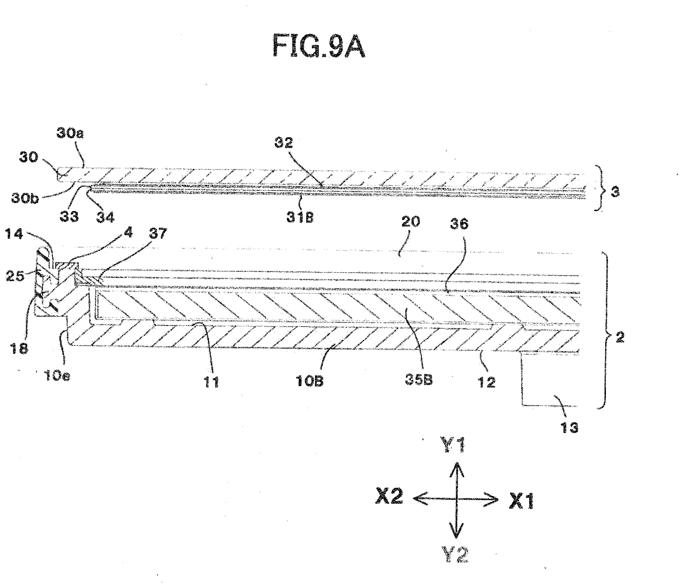

Fig. 9A is a partial cross-sectional view cutting the display device of the first embodiment of the present disclosure illustrated in Fig. 2 along the line IX-IX, and illustrating a state before the cover plate is bonded to the front of the rear support;

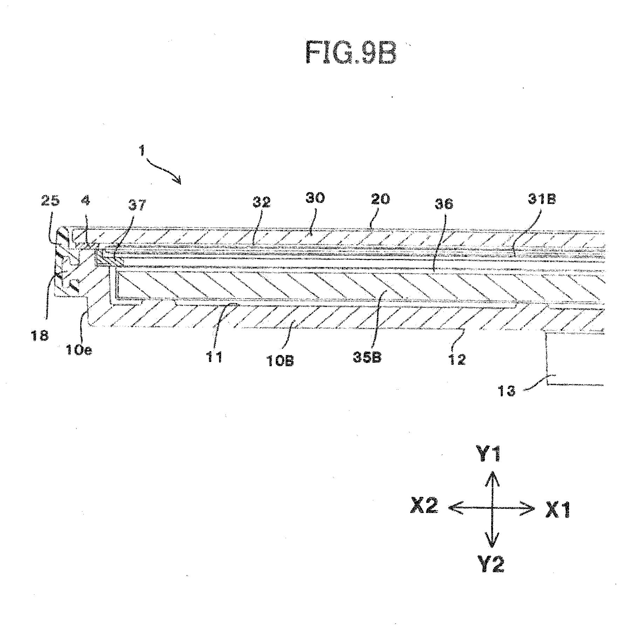

Fig. 9B is a partial cross-sectional view cutting the display device of the first embodiment of the present disclosure illustrated in Fig. 2 along the line IX-IX, and illustrating a state in which the cover plate is bonded to the front of the rear support;

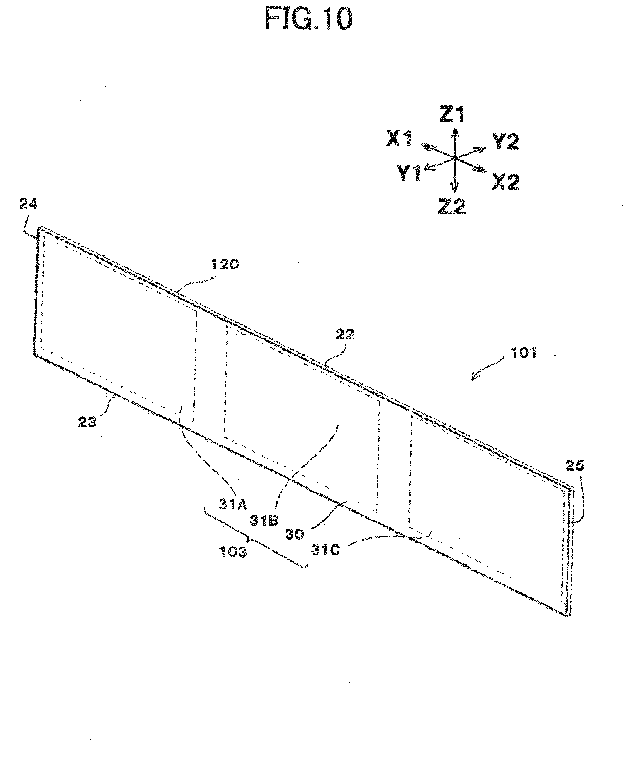

Fig. 10 is a perspective view illustrating a display device of a second embodiment of the present disclosure as viewed from the front;

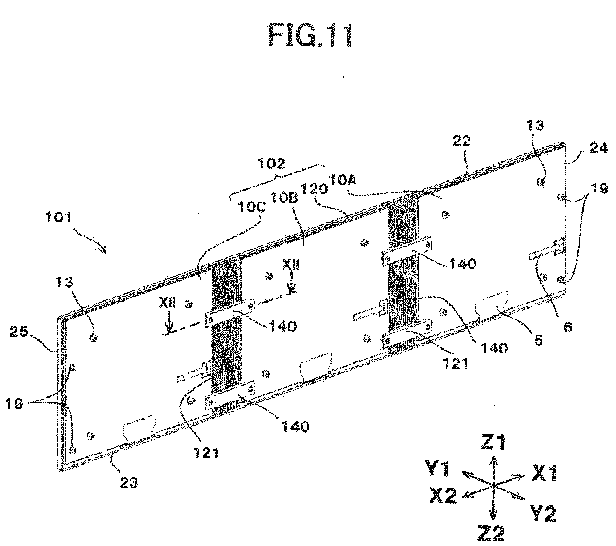

Fig. 11 is a perspective view illustrating the display device of the second embodiment of the present disclosure as viewed from the rear;

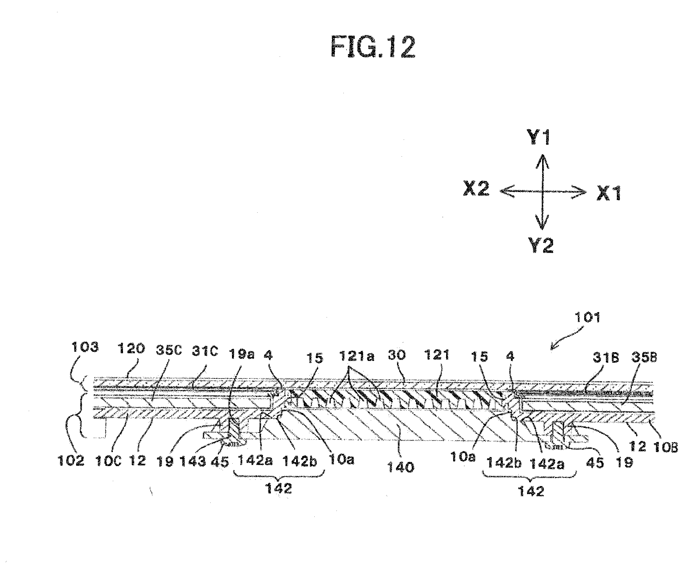

Fig. 12 is a partial cross-sectional view cutting the display device of the second embodiment of the present disclosure illustrated in Fig. 11 along the line XII-XII;

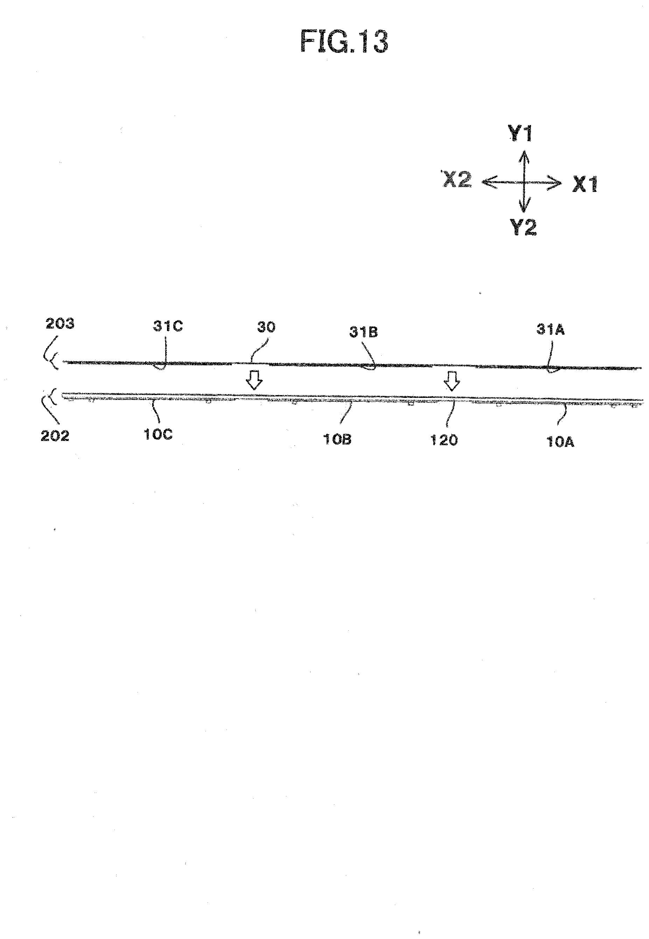

Fig. 13 is a plan view illustrating a method of producing a display device of a third embodiment of the present disclosure, and illustrating a process of bonding a cover plate to a connected support member in which three rear supports are connected;

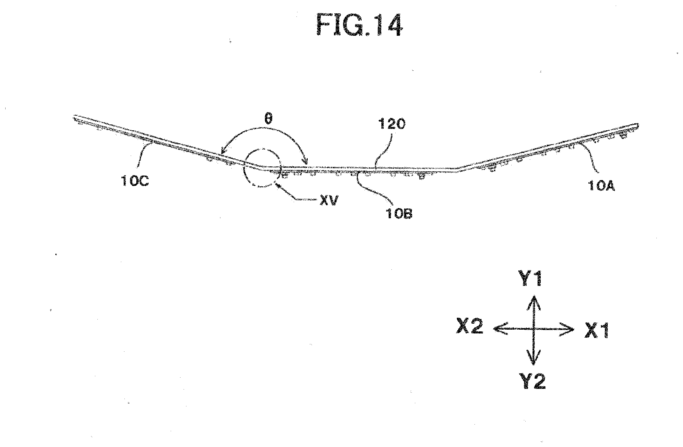

Fig. 14 is a plan view illustrating the method of producing the display device of the third embodiment of the present disclosure, and illustrating processes of bonding the cover plate to the connected support member in which three rear supports are connected, and deforming the resin connector and the cover plate to set angles of front surfaces of a pair of the adjacent rear supports to each be less than 180 degrees;

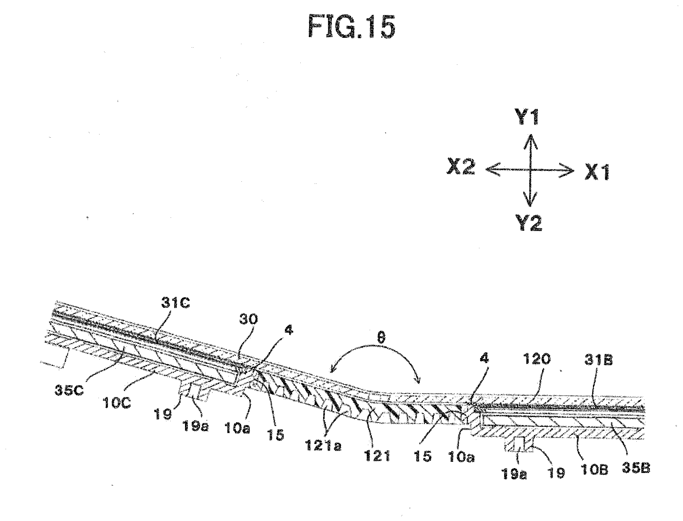

Fig. 15 is an enlarged cross-sectional view of the XV portion of the display device illustrated in Fig. 14, which illustrates a modified state of the resin connector;

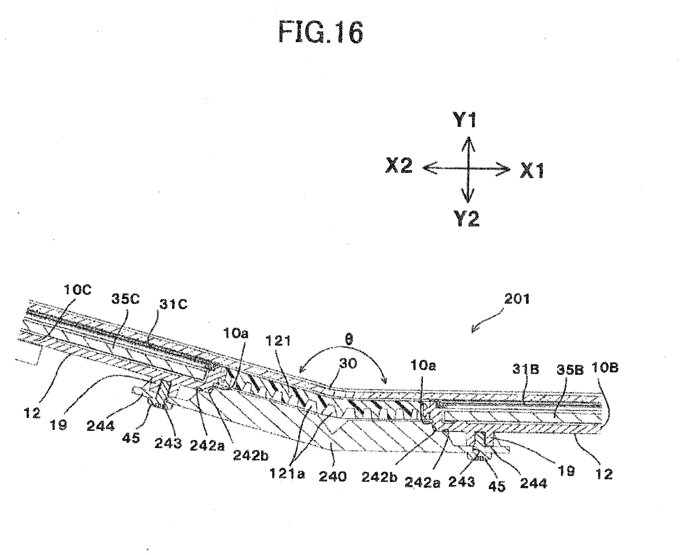

Fig. 16 is a partial cross-sectional view illustrating a state in which a connection support member is attached to the display device illustrated in Fig. 15 to fix a relative position of the adjacent rear supports;

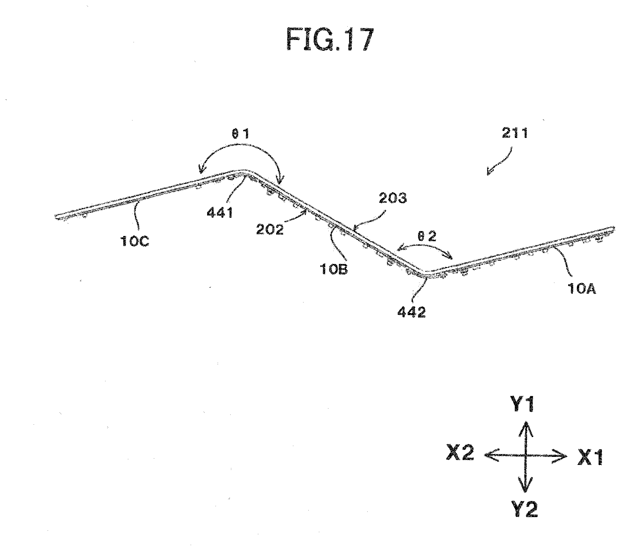

Fig. 17 is a plan view illustrating another configuration example of the display device of the third embodiment of the present disclosure, and illustrating the display device in which the resin connectors and the cover plate are deformed to set angles of the front surfaces of pairs of the adjacent rear supports to be greater than 180 degrees and less than 180 degrees, respectively, using the connected support member in which which three rear supports are connected;

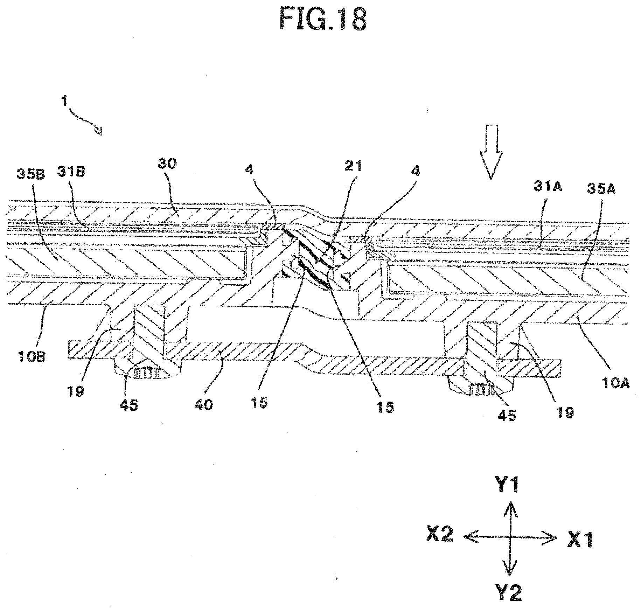

Fig. 18 is a partial cross-sectional view illustrating the same portion to that of Fig. 6B, and describing a shock-absorbing action of the display device of the first embodiment of the present disclosure;

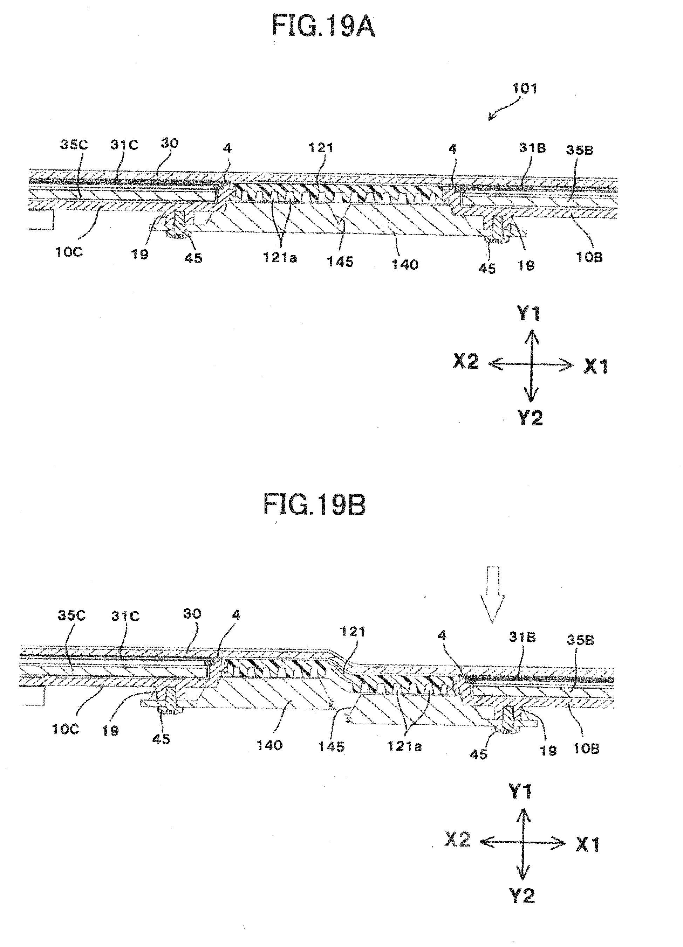

Fig. 19A is a partial cross-sectional view illustrating the same portion to that of Fig. 12 describing a shock-absorbing action of the display device of the second embodiment of the present disclosure, and illustrating a state before an impact is applied;
Fig. 19B is a partial cross-sectional view illustrating the same portion to that of Fig. 12 describing a shock-absorbing action of the display device of the second embodiment of the present disclosure, and illustrating a state after an impact is applied; and

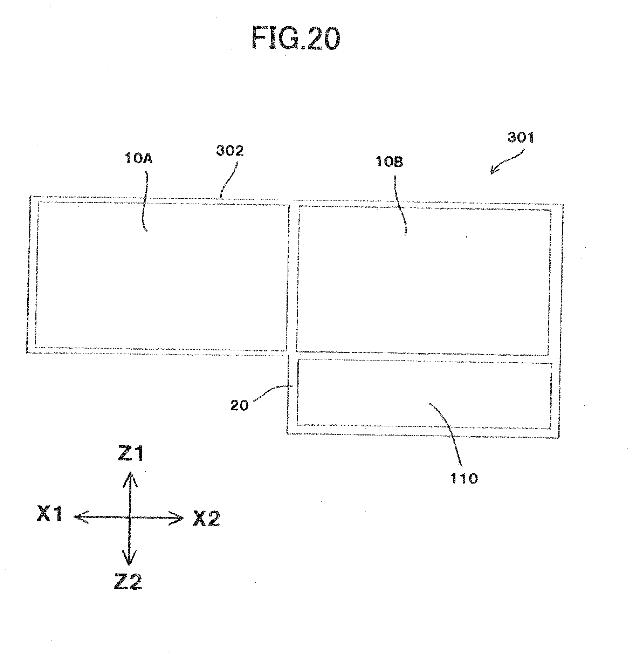

Fig. 20 is a front view illustrating a display device of a fourth embodiment of the present disclosure as viewed from the front side.

The in-vehicle display device disclosed in JP 2021-138342 A has the following problems.
(1) Since display panels are laterally aligned and held in the holder, the length dimension of the holder in the lateral direction becomes large as illustrated in Fig. 1. Therefore, it is difficult to maintain high dimensional precision during production of a holder, and it is particularly difficult to attain a flatness of a surface defined by the display panels with high precision.
(2) Since the holder that holds the multiple display panels and has a large size in the lateral direction is formed of a resin material in JP 2021-138342 A, bending or warping caused during molding is likely to remain in the holder. Therefore, it is difficult to achieve production of a uniform product. When the holder is secured inside a vehicle, the holder is likely to be partially lifted up from a fixture. To solve the above problem, the holder is preferably formed of a metal material. However, in the case where multiple display panels are held in the holder integrally formed of a metal, if a noise occurs in a display panel due to electrostatic discharge (ESD) caused when the display panel is controlled with a finger, the static electricity is likely to transmit through the metal holder, thereby adversely affecting other display panels.
(3) If the holder having a curvature is used as illustrated in Figs. 3 and 11 of JP 2021-138342 A, it is necessary to curve a cover plate (e.g., a glass plate) in advance to correspond to the curvature of the holder when the cover plate is bonded to the front surface of the holder. Thus, an assembling process becomes very complicated.

The present disclosure aims to provide a display device that can maintain a high overall dimensional precision in a structure including multiple display panels, and can inhibit adverse effects of electrostatic discharge from spreading between the display panels.

In addition, the present disclosure aims to provide a method of producing a display device, which can produce a structure in which multiple display panels are covered with a common cover plate at high dimensional precision, and can relatively easily produce, for example, a structure in which a pair of adjacent display panels are arranged to form an angle other than 180 degrees therebetween.

The display device of the present disclosure preferably includes a resin frame that is formed continuously along an outer periphery of the rear supports connected with one another via the resin connector. The resin frame is preferably formed integrally with the resin connector.

In the display device of the present disclosure, among the rear supports, two or more rear supports preferably have an identical shape and an identical size.

In the display device of the present disclosure, the resin connector preferably has a recess that descends forward or rearward.

The display device of the present disclosure preferably further includes a connection support member that is fastened to a rear of each pair of the rear supports adjacent to each other across the resin connector. The connection support member is preferably configured to determine relative positions, in a longitudinal direction, of each pair of the rear supports adjacent to each other.

In the display device of the present disclosure, the connection support member may include a recess that descends forward or rearward.

In the display device of the present disclosure, front surfaces of respective rear supports in each pair of the rear supports adjacent to each other, which are connected via the resin connector, can form an angle other than 180 degrees between the front surfaces.

In the display device of the present disclosure, the display panels are, for example, liquid crystal display panels, and backlight units are retained in the rear supports, respectively.

According to another aspect of the present disclosure, a method of producing a display device, which includes rear supports, a cover plate that is translucent and fastened to a front of the rear supports, and display panels disposed between the rear supports and the cover plate, includes: (a) connecting the rear supports with one another via a resin connector; and (b) covering, with the cover plate, the front of the rear supports connected with one another via the resin connector, and fastening the cover plate to each of the rear supports. The display panels are disposed corresponding to the rear supports, respectively.

The method of producing the display device of the present disclosure preferably further includes: forming a resin frame integrally with the resin connector, the resin frame being continuous along an outer periphery of the rear supports connected with one another via the resin connector.

In the method of producing the display device of the present disclosure, the resin connector and the resin frame may be integrally formed, for example, by insert molding.

The method of producing the display device of the present disclosure preferably further includes: fastening a connection support member to a rear of each pair of the rear supports adjacent to each other across the resin connector, and relatively positioning, in a longitudinal direction, each pair of the rear supports adjacent to each other using the connection support member.

According to yet another aspect of the present disclosure, a method of producing a display device, which includes rear supports, a cover plate that is translucent and fastened to a front of the rear supports, and display panels disposed between the rear supports and the cover plate, includes: (a) connecting rear supports with one another via a resin connector; (b) covering, with the cover plate, the front of the rear supports connected with one another via the resin connector, and fastening the cover plate to each of the rear supports; (c) after (b), deforming the resin connector and the cover plate so that front surfaces of respective rear supports in each pair of the rear supports adjacent to each other, which are connected via the resin connector, form an angle other than 180 degrees between the front surfaces; and (d) fastening a connection support member to the rear of each pair of the rear supports adjacent to each other across the resin connector to fix relative positions of each pair of the rear supports adjacent to each other.

The method of producing the display device also preferably further includes: forming a resin frame integrally with the resin connector, the resin frame being continuous along an outer periphery of the rear supports connected with one another via the resin connector.

The display device according to aspects of the present disclosure includes rear supports having a small size compared to the size of the entire display device. Thus, a high dimensional precision of each rear support, particularly high flatness, can be achieved so that notable warping or the like is unlikely to occur. For this reason, the display device, in which the multiple rear supports are connected via one or more resin connectors, minimizes overall warping, and therefore a phenomenon such that part of the rear support is lifted from an attachment portion when the display panel is mounted on a vehicle or the like is unlikely to occur. Even if electrostatic discharge to one of display panels occurs with rear supports formed of a metal, the resin connector is interposed between the adjacent rear supports, and therefore transmission of electrostatic electricity to another rear support can be inhibited.

According to aspects of the method of producing the display device of the present disclosure, the resin connectors connecting pairs of the rear supports adjacent to each other or the frame surrounding the outer periphery of the rear supports is formed by insert molding or the like, and therefore the connected support member, in which the multiple rear supports are connected, can be produced at high precision with a relatively simple process. In addition, a structure in which each pair of the rear supports adjacent to each other are arranged with an angle other than 180 degrees therebetween, specifically an angle less than 180 degrees or greater than 180 degrees, can also be easily achieved.

### <Display device 1 of first embodiment>

Figs. 1 and 2 illustrate an overall configuration of a display device 1 according to a first embodiment of the present disclosure. As the orientation of the display device 1, the direction Y1-Y2 is a longitudinal direction (front-rear direction), the direction Y1 is a forward direction that is a display direction, and the direction Y2 is a rearward direction. The direction X1-X2 is a lateral direction (left-right direction), the direction X1 is a left direction, and the direction X2 is a right direction. The direction Z1-Z2 is a vertical direction (up-down direction), the direction Z1 is an upward direction, and the direction Z2 is a downward direction. The display device 1 is designed to be disposed, for example, in a vehicle, and is disposed on an instrument panel or a dashboard provided at a front of the interior of the vehicle. The front (the direction Y1) of the display device 1 is directed toward the interior of the vehicle so that a driver and passengers can view the contents of the display. However, the display device 1 may be used for domestic use, in offices, or in game arcades.

As illustrated in the exploded perspective view of Fig. 3, the display device 1 includes a connected support member 2 and a cover assembly 3 covering the front (the direction Y1) of the connected support member 2. The connected support member 2 includes two rear supports 10A and 10B, and a molded resin body 20 attached to the two rear supports 10A and 10B. As illustrated in Fig. 4, the two rear supports 10A and 10B remain independent of each other, but the rear support 10A and the rear support 10B have the identical shape and the identical size. The rear supports 10A and 10B are each formed of a metal material. For example, the rear supports 10A and 10B are formed by die-casting a magnesium alloy, an aluminum alloy, or the like. Moreover, the rear supports 10A and 10B may be formed by press molding a galvanized steel plate or the like.

As illustrated in Figs. 3 and 4, the shape of each of the two rear supports 10A and 10B as viewed from the front is a square or a rectangular. As illustrated in the cross-sectional view of Fig. 5, each of the rear support 10A and the rear support 10B is a case having a housing recess 11 that is open to the front (the direction Y1). The shape of the housing recess 11 as viewed from the front is rectangular. As illustrated in Figs. 2 and 5, two or more fastening protrusions 13 are integrally formed on the rear surface 12 of each of the rear supports 10A and 10B, which faces rearward (the direction Y2). In each fastening protrusion 13, a female screw hole 13a is formed. When the display device 1 illustrated in Figs. 1 and 2 is mounted inside a vehicle, the fastening protrusions 13 are secured on a fastening plate disposed on a dashboard or inside an instrument panel with screws.

As illustrated in Fig. 2, the connected support member 2 includes the two rear supports 10A and 10B, and a molded resin body 20, which are integrally formed by insert molding. During the insert molding, a molten resin is injected into a cavity of a mold in which the two rear supports 10A and 10B are aligned and disposed, thereby forming the molded resin body 20. At the same time, the two rear supports 10A and 10B are bound and integrated with the molded resin body 20. The molded resin body 20 is formed of a thermoplastic resin, such as a polycarbonate (PC) resin, an ABS resin, or the like, preferably a thermoplastic elastomer (TPE), such as a thermoplastic copolyester elastomer (TPC). Since each of the rear supports 10A and 10B is formed of a metal, the molded resin body 20 has a lower elastic modulus (tensile strength, shear strength, or bulk modulus) than each rear support 10A or 10B. The rear supports 10A and 10B may be formed by injection molding of a hard resin material, as long as the elastic modulus of each rear support 10A or 10B is higher than the elastic modulus of the molded resin body 2O. In order to maintain a high dimensional precision for smoothness or the like, the rear supports 10A and 10B are preferably formed of a metal.

As illustrated in Fig. 3, the molded resin body 20 includes a resin connector 21, an upper frame 22, a lower frame 23, a left frame 24, and a right frame 25. The resin connector 21 binds an opposing side 10a that is the right side of the left rear support 10A and an opposing side 10a that is a left side of a right rear support 10B in a manner such that the resin connector 21 is in close contact with the opposing sides 10a. The upper frame 22 is in close contact with the upper side 10b of the rear support 10A and the upper side 10b of the rear support 10B. The lower frame 23 is in close contact with the lower side 10c of the rear support 10A and the lower side 10c of the rear support 10B. The left frame 24 is in close contact with the left side 10d of the rear support 10A on the left side (X1 side). The right frame 25 is in close contact with the right side 10e of the rear support 10B on the right side (X2 side). The upper frame 22, the lower frame 23, the left frame 24, and the right frame 25 constitute a "resin frame."

Figs. 6A and 6B illustrate a cross-sectional structure of the resin connector 21 connecting the opposing side 10a that is the right side of the left rear support 10A and the opposing side 10a that is the left side of the right rear support 10B. A locking projection 15 is integrally formed on each of the opposing sides 10a of the left and right rear supports 10A and 10B. The locking projection 15 is continuously or intermittently formed along each opposing side 10a in the vertical direction. During the insert molding, a molten thermoplastic resin is injected and cooled in a cavity in which the left and right locking projections 15 face each other, thereby forming the resin connector 21 having a structure in which the locking projections 15 are inserted from the left and right into the region between the left and right opposing sides 10a.

Figs. 8A and 8B illustrate a cross-sectional structure including the upper side 10b of the rear support 10A and the upper frame 22 that is part of the resin frame. As illustrated in Figs. 5 and 8, a locking projection 16 is formed integrally on the upper side 10b of each of the left and right rear supports 10A and 10B. The locking projection 16 is continuously or intermittently formed along each rear support 10A or 10B in the lateral direction. During the insert molding, a molten thermoplastic resin is injected and cooled in a cavity in which the locking projections 16 of the rear supports 10A and 10B are aligned laterally, thereby forming the upper frame 22 having a structure in which the locking projections 16 are inserted. As illustrated in Fig. 5, a locking projection 17 is formed on the lower side 10c of each of the left and right rear supports 10A and 10B, thereby forming, through insert molding, the lower frame 23 having the shape in which the locking projections 17 are inserted.

Figs. 9A and 9B illustrate a cross-sectional structure of the right side 10e of the right rear support 10B and the right frame 25. A locking projection 18 is integrally formed on the right side 10e of the rear support 10B. The locking projection 18 is formed continuously or intermittently in the vertical direction. When the resin frame is formed by the insert molding, the right frame 25 having the shape in which the locking projection 18 is inserted is formed. In a similar manner, a locking projection is integrally formed on the left side 10d of the left rear support 10A, and the left frame 24, in which the locking projection is inserted, is formed by insert molding.

In the "resin frame" formed by insert molding, the upper frame 22 is formed continuously along the upper side 10b of the left rear support 10A and the upper side 10b of the right rear support 10B, and the lower frame 23 is also formed continuously along the lower side 10c of the left rear support 10A and the lower side 10c of the right rear support 10B. The upper frame 22, the lower frame 23, the left frame 24, and the right frame 25 are all formed to be continuous with one another, thereby forming a rectangular frame. The resin connector 21 is continuous with and is formed integrally with the upper frame 22 and the lower frame 23. The connected support member 2, in which the two rear supports 10A and 10B and the molded resin body 20 are integrated, has a structure where the resin frame that is continuously provided, without being interrupted, along the outer periphery of the two rear supports 10A and 10B connected with the resin connector 21. Therefore, even in the case where the rear supports 10A and 10B are independently formed, the connected support member 2 can be handled as an integrated component. Since the resin frame (upper frame 22, lower frame 23, left frame 24, and right frame 25), which is provided continuously along the outer periphery (upper side 10b, lower side 10c, left side 10d, and right side 10e) of the two rear supports 10A and 10B, is formed without being interrupted, the display device 1 has an integrated appearance.

As illustrated in Fig. 2, connection support members 40 are fastened to the rear of the adjacent rear supports 10A and 10B across the opposing edges of the rear supports 10A and 10B. Two connection support members 40 are disposed to be set apart from each other in the vertical direction (the direction Z1-Z2), and each connection support member 40 is fastened to the rear surfaces 12 of the rear supports 10A and 10B across the resin connector 21. Each connection support member 40 is formed by die-casting using the same metal material as the material used for forming the rear supports 10A and 10B, or formed by bending a metal plate. Alternatively, each connection support member 40 is formed by injection molding a hard resin. As illustrated in the cross-sectional view of Fig. 7, each connection support member 40 includes an attachment portion 41 parallel to the rear surfaces 12 of the rear supports 10A and 10B, and a positioning portion 42 extending forward and being continuous with the upper side and the lower side of the attachment portion 41. As illustrated in Figs. 6A and 6B, fastening holes 43 are formed in the attachment portion 41 so that the fastening holes 43 are set apart from each other in the lateral direction. As illustrated in Fig. 7, the front edge of positioning portion 42 is a positioning surface 42a. As illustrated in Figs. 6A and 6B, the positioning surface 42a is linearly and continuously formed in the lateral direction (the direction X1-X2) parallel to the rear surfaces 12 of the rear supports 10A and 10B.

As illustrated in Fig. 2, on each of the rear support 10A and the rear support 10B, two fastening protrusions 19 protruding rearward are disposed on the right part of the rear surface 12 and two fastening protrusions 19 protruding rearward are disposed on the left part of the rear surface 12, and a female screw hole 19a is formed in each fastening protrusion 19. Two fastening screws 45 are respectively inserted into the fastening holes 43 formed in each connection support member 40, and are screwed into the female screw holes 19a of the pair of the fastening protrusions 19 facing each other across the resin connector 21, thereby fastening the connection support members 40 to the rear supports 10A and 10B. When a connection support member 40 is fastened as illustrated in Fig. 6, the positioning surface 42a of the connection support member 40 is abutted against the rear surface 12 of the left rear support 10A and the rear surface 12 of the right rear support 10B, which are positioned across the resin connector 21 from each other. When the positioning surface 42a of the connection support member 40 is abutted against the rear surfaces 12 of the left and right rear supports 10A and 10B, the resin connector 21 is slightly deformed so that the rear surface 12 of the rear support 10A and the rear surface 12 of the rear support 10B become substantially flush with each other, and the rear supports 10A and 10B are positioned in the longitudinal direction. Thus, it is possible to maintain relative flatness between the front surface 14 (the front surface positioned around the housing recess 11) of the left rear support 10A and the front surface 14 of the right rear support 10B at high precision.

The two rear supports 10A and 10B and the molded resin body 20 are integrated by insert molding, and the adjacent rear supports 10A and 10B are secured and positioned by the two connection support members 40, i.e. the upper and lower connection support members 40, thereby producing the connected support member 2.

As illustrated in Figs. 6A, 8A, and 9A, the cover assembly 3 is assembled independently of the connected support member 2. The cover assembly 3 includes a translucent cover plate 30. The term "translucent" indicates, for example, that the cover plate has a total light transmittance of preferably 60% or greater, more preferably 90% or greater. As illustrated in Figs. 1 and 3, the one cover plate 30 has an area covering all of the rear supports constituting the connected support member 2, and has an area covering the front of the two rear supports 10A and 10B in the display device 1 of the first embodiment. The cover plate 30 is formed of a glass plate or a resin plate of polycarbonate or the like. In order to secure flatness over a large area, the cover plate 30 is preferably formed of a glass plate. For the display device 1 of the first embodiment, which is used as an in-vehicle display device, a tempered glass plate having a thickness of approximately 0.8 mm is used.

As illustrated in Figs. 6A, 8A, and 9A, the cover plate 30 includes a front surface 30a facing forward (the direction Y1) and a rear surface 30b facing the rearward (the direction Y2). Two display panels 31A and 31B are disposed on the rear surface 30b of the cover plate 30, and the display panels 31A and 31B are bonded to the rear surface 30b of the cover plate 30 with an optical adhesive layer 32. The display panel 31A and the display panel 31B are liquid display panels having the identical structure and the identical size. As illustrated in Fig. 6A, in each of the display panel 31A and the display panel 31B, a front glass substrate 33 and a rear glass substrate 34 are stacked, and a transparent electrode is formed on each of the opposing surfaces of the glass substrates 33 and 34. A liquid crystal material is sealed inside a gap between the front glass substrate 33 and the rear glass substrate 34, and a color filter is disposed on one of the opposing surfaces of the glass substrates. The front glass substrate 33 is bonded to the rear surface 30b of the cover plate 30 with an optical adhesive layer 32.

In the cover assembly 3, a transparent touchscreen sensor is interposed between the front glass substrate 33 of the display panel 31A and the cover plate 30, and a transparent touchscreen sensor is also interposed between the front glass substrate 33 of the display panel 31B and the cover plate 30. The touchscreen sensor has a transparent electrode, and is configured to detect a capacitance change when the user's finger comes close to the front surface 30a of the cover plate 30, thereby detecting a touch position or approaching position of the finger.

As illustrated in Figs. 5, 6, 8A, and 8B, the left rear support 10A is a case, and has the housing recess 11 that is open to the front. A backlight unit 35A and an optical sheet 36, such as a light-scattering sheet or the like, stacked on the front surface of the backlight unit 35A, are housed and supported inside the housing recess 11. A spacer 37 is attached to the front of the optical sheet 36. As illustrated in Figs. 6A, 6B, 9A and 9B, a backlight unit 35B, an optical sheet 36, and a spacer 37 are also housed and supported inside the housing recess 11 of the right rear support 10B. The backlight unit 35A and the backlight unit 35B are identical, and each backlight unit includes a light source, such as multiple LEDs or the like, and a light guide plate that guides light from the light source to irradiate the display panel 31A or 31B.

As illustrated in Figs. 6A, 8A, and 9A, an adhesive layer 4 is disposed on the front surfaces 14 of the rear supports 10A and 10B. The adhesive layer 4 is disposed on the front surface 14 to surround the entire periphery of the housing recess 11. As illustrated in Figs. 6B, 8B, and 9B, the rear surface 30b of the cover plate 30 is adhered to the front surface 14 of the adhesive layer 4. As the adhesive layer 4, a double-sided adhesive tape or the like is used. When the cover assembly 3 is fastened to the front of the connected support member 2, the left display panel 31A is positioned between the left rear support 10A and the cover plate 30, and most of the display panel 31A is positioned inside of the housing recess 11 of the rear support 10A. The right display panel 31B is positioned between the right rear support 10B and the cover plate 30, and most of the display panel 31B is positioned inside the housing recess 11 of the rear support 10B. Moreover, the backlight unit 35A faces the rear of the left display panel 31A, and the backlight unit 35B faces the rear of the right display panel 31B.

When the cover plate 30 constituting the cover assembly 3 is adhered and fastened to the front surfaces 14 of the rear supports 10A and 10B constituting the connected support member 2 as illustrated in Figs. 6B, 8B, and 9B, assembly of the display device 1 is completed. Since the cover assembly 3 illustrated in Fig. 1 is viewed from the front, regions of the cover plate 30 where the display panels 31A and 31B are disposed are indicated with dashed lines, respectively. The regions surrounded by the dashed lines, respectively, are display regions of the display device 1.

As illustrated in Fig. 2, flexible wiring substrates 5 and 6 of the display device 1 are visible at the rear surfaces of the rear supports 10A and 10B. These flexible wiring substrates 5 and 6 are electrically connected to the transparent electrodes of the display panels 31A and 31B to electrically connect with the transparent electrodes of the touchscreen sensors, and also apply driving power to the backlight units 35A and 35B. When driving signals are applied to the display panels 31A and 31B via the flexible wiring substrates 5 and 6 to thereby apply driving power to the backlight units 35A and 35B, an image is displayed in the display regions surrounded by the dashed lines in Fig. 1. Moreover, a detection signal when a finger touches the front surface 30a of the cover plate 30 is detected by the touchscreen sensor, and the detected signal is output to a detection circuit positioned at the rear via either of the flexible wiring substrates 5 and 6.

Note that the display device of the present disclosure may use self-emitting display panels without backlight units, such as organic electroluminescence elements or the like, as the display panels 31A and 31B. In this case, the display panel 31A is disposed between the cover plate 30 and the rear support 10A, and the display panel 31B is disposed between the cover plate 30 and the rear support 10B.

### <Method of producing display device 1 of first embodiment>

The display device 1 is assembled by the following processes.
(a) Two rear supports 10A and 10B and a molded resin body 20 are integrated by insert molding, thereby forming a resin connector 21 connecting the rear supports 10A and 10B, as well as a "resin frame" which is in close contact with a periphery of the rear supports 10A and 10B except for at the regions connected with the resin connector 21. In addition, connection support members 40 are fastened to the rear of the rear supports 10A and 10B across the resin connector 21, thereby producing a connected support member 2.
(b) Separately from (a), display panels 31A and 31B are bonded to a rear surface 30b of a cover plate 30, and a touchscreen sensor is interposed between the rear surface 30b and each of the display panels 31A and 31B, thereby producing a cover assembly 3.
(c) Backlight units 35A and 35B, optical sheets 36, and spacers 37 are respectively disposed inside housing recesses 11 of the rear supports 10A and 10B of the connected support member 2.
(d) The cover plate 30 is bonded and fastened to the front surfaces 14 of the rear supports 10A and 10B via an adhesive layer 4, thereby completing production of a display device 1.

### <Display device 101 of second embodiment>

A display device 101 of a second embodiment illustrated in Figs. 10 and 11 has a same basic configuration as the display device 1 of the first embodiment. As illustrated in Fig. 11, the display device 101 includes a connected support member 102 in which three rear supports 10A, 10B, and 10C are connected with a molded resin body 120. The rear support 10A, the rear support 10B, and the rear support 10C have the identical structure and identical size, and are the same as the rear supports 10A and 10B in the connected support member 2 of the first embodiment. As illustrated in Fig. 12, backlight units 35A, 35B, or 35C, optical sheets 36, and the like are housed respectively in housing recesses 11 of the rear supports 10A, 10B, and 10C. As illustrated in Fig. 10, the display device 101 includes the cover assembly 103 in which the three display panels 31A, 31B, and 31C are bonded to the rear surface of the cover plate 30. The display panel 31A, the display panel 31B, and the display panel 31C have the identical structure and identical size, and are the same as the display panels 31A and 31B of the cover assembly 3 of the first embodiment. As illustrated in Fig. 10, the display device 101 has three display regions each surrounded by a dashed line.

In the production process of the connected support member 102 illustrated in Figs. 10 and 11, the three rear supports 10A, 10B, and 10C, and the molded resin body 120 are integrated by insert molding. The molded resin body 120 includes two resin connectors 121 and a "resin frame." The "resin frame" includes an upper frame 22, a lower frame 23, a left frame 24, and a right frame 25, which are continuous with one another. The cross-sectional shapes of the upper frame 22, the lower frame 23, the left frame 24, and the right frame 25 are the same as the cross-sectional shape of the "resin frame" of the first embodiment illustrated in Figs. 8A, 8B, 9A, and 9B. As illustrated in the cross-sectional view of Fig. 12, the cross-sectional shape of the resin connector 121 of the second embodiment is different from the cross-sectional shape of the resin connector 21 of the display device 1 of the first embodiment.

As illustrated in Fig. 12, a locking projection 15 is formed on each of the opposing side 10a of the rear support 10B and the opposing side 10a of the rear support 10C. The left and right locking projections 15 are inserted into the resin connector 121 to be formed by insert molding, thereby connecting the rear supports 10B and 10C together. The width of the resin connector 121 in the lateral direction (the direction X1-X2) is larger than the width of the resin connector 21 of the display device 1 of the first embodiment. Two or more recesses 121a descending from the rear surface to the front are formed in the resin connector 121 so that the resin connector 121 is readily deformed. Only one recess 121a can also be formed. Alternatively, each recess may be formed to descend from the front surface of the resin connector 121 toward the rear, or recesses descending toward the front and recesses descending toward the rear may coexist. Note that the opposing side 10a of the rear support 10A and the opposing side 10a of the rear support 10B are also connected with the resin connector 121 having the same structure as illustrated in Fig. 12.

As illustrated in Fig. 11, connection support members 140 are fastened to the adjacent rear supports 10A and 10B across the resin connector 121, and connection support members 140 are fastened to the adjacent rear supports 10B and 10C across the resin connector 121. As illustrated in Fig. 12, two fastening holes 143 are formed in the connection support member 140 at the left and right, respectively. On each of the rear surfaces 12 of the left and right rear supports 10B and 10C, a fastening protrusion 19 is formed in the vicinity of the opposing side 10a to project from the rear surface 12. The connection support member 140 is secured on the rear of the adjacent rear supports 10B and 10C by screwing fastening screws 45 inserted into the fastening holes 143, respectively, to the corresponding female screw holes 19a of the fastening protrusions 19.

As illustrated in Fig. 12, positioning portions 142 are provided to the connection support member 140, and are set apart from each other in the lateral direction. Each positioning portion 142 includes a longitudinal positioning surface 142a and a lateral positioning surface 142b. When the connection support member 140 is fastened to the adjacent rear supports 10B and 10C, the longitudinal positioning surfaces 142a are abutted against the rear surfaces 12 of the adjacent rear supports 10B and 10C to determine relative positions of the adjacent rear supports 10B and 10C in the longitudinal direction. In addition, the lateral positioning surfaces 142b are interposed between the rear support 10B and the rear support 10C, and compressed by the opposing sides 10a of the adjacent rear supports 10B and 10C, thereby determining the relative positions of the adjacent rear supports 10B and 10C in the lateral direction. The connection support member 140 performs the same connection and positioning between the rear support 10A and the rear support 10B.

A method of producing the display device 101 of the second embodiment is substantially the same as the method of producing the display device 1 of the first embodiment. As illustrated in Fig. 11, the display device 101 of the second embodiment has a large width in the lateral direction (the direction X1-X2) and has a large total area of the display regions each surrounded by the dashed line, and therefore the display device 101 can implement various display modes when used as an in-vehicle display or the like.

### <Method of producing display device 201 or 211 of third embodiment>

As illustrated in Figs. 13 to 17, a display device 201 or 211 of a third embodiment includes, similar to the display device 101 of the second embodiment, a connected support member 202, in which three rear supports 10A, 10B, and 10C and a molded resin body 120 are connected, three backlight units 35A, 35B, and 35C, which are housed in rear supports 10A, 10B, and 10C, respectively, and a cover assembly 203 in which three display panels 31A, 31B, and 31C are adhered to a rear surface of a cover plate 30. In the display device 201 and the display device 211, an opening angle in the forward direction (the direction Y1) formed between adjacent rear supports (along with the cover plate 30 bonded thereto) is an angle other than 180 degrees. The display device 201 illustrated in Figs. 14 to 16 is configured in a manner such that an opening angle θ in the forward direction (the direction Y1) formed between the adjacent rear supports 10A and 10B (along with the cover plate 30 bonded thereto), and an opening angle θ in the forward direction (the direction Y1) formed between the adjacent rear supports 10B and 10C (along with the cover plate 30 bonded thereto) are set to be less than 180 degrees. For example, the opening angle θ is 120 degrees or greater and 170 degrees or less. The display device 211 illustrated in Fig. 17 is configured such that an opening angle θ2 in the forward direction formed between the adjacent rear supports 10A and 10B (along with the cover plate 30 bonded thereto) is less than 180 degrees, and an opening angle θ1 formed in the forward direction between the adjacent rear supports 10B and 10C (along with the cover plate 30 bonded thereto) is greater than 180 degrees. For example, the angle θ1 is 190 degrees or greater and 240 degrees or less. However, each angle θ, θ1, or θ2 may be an angle outside the above ranges.

The method of producing the display device 201 includes production of a connected support member 202, in which a molded resin body 120 is connected to three rear supports 10A, 10B, and 10C by insert molding as illustrated in Fig. 13. In addition, a cover assembly 203, in which three display panels 31A, 31B, and 31C are adhered to a rear surface of a cover plate 30, is produced. The cover plate 30 is adhered to front surfaces of the rear supports 10A, 10B, and 10C via an adhesive layer 4 to fasten the cover assembly 203 to the front of the connected support member 202. The production method for the connected support member 202, the production method for the cover assembly 203, and the production process up to the fastening of the connected support member 202 to the cover assembly 203 are the same as those for the display device 101 of the second embodiment.

In the method of producing the display device 201 of the third embodiment, as illustrated in Fig. 13, the flat connected support member 202 and the flat cover assembly 203 are joined together, and then a sufficient curing time is provided to strongly join the connected support member 202 and the cover assembly 203 together. Then, mechanical external force is applied at room temperature or with heat to deform the resin connector 121, and also deform the cover plate 30, thereby bending in a manner such that an opening angle θ in the forward direction formed between the rear supports 10B and 10C (along with the cover plate 30 adhered thereto) becomes less than 180 degrees as illustrated in Fig. 14. In a similar manner, the resin connector 121 and the cover plate 30 are bent such that an opening angle θ formed in the forward direction between the adjacent rear supports 10A and 10B (along with the cover plate 30 adhered thereto) becomes less than 180 degrees.

Fig. 15 is an enlarged cross-sectional view of the VX portion of Fig. 14. As illustrated in Fig. 15, the opening angle θ formed between the adjacent rear support 10B and the rear support 10C becomes less than 180 degrees due to deformation of the resin connector 121. The cover plate 30 is a glass plate having a thickness of approximately 0.8 mm. The glass plate 30 has, for example, a large area with dimensions of 600 mm or greater in the lateral direction and 300 mm or greater in the longitudinal direction. Therefore, when the resin connector 121 is deformed, the cover plate 30 strongly adhered to the front surfaces of the rear supports 10B and 10C via the adhesive layer 4 can be deformed to follow the opening angle formed between the rear supports 10B and 10C without detaching from the rear supports 10B and 10C. In the case where the cover plate 30 is formed of a thermoplastic resin, such as polycarbonate, at the time when an external force is applied to the rear supports 10B and 10C, a level of heat that does not cause the cover plate 30 to discolor is applied to facilitate deformation of the cover plate 30 to follow the shape formed by the rear supports 10B and 10C.

After applying the external force to bend and provide a suitable shape for the rear supports 10B and 10C, and the cover plate 30 adhered to the rear supports 10B and 10C, the connection support members 240 are fastened to the rear of the adjacent rear supports 10B and 10C, as illustrated in Fig. 16. Each connection support member 240 is produced in advance in a manner such that attachment portions 244 provided at the left and right edges are matched with the opening angle θ. Fastening screws 45 inserted into attaching holes 243 formed in the attachment portions 244 are screwed into the corresponding fastening protrusions 19 formed on the rear surfaces 12 of the rear supports 10B and 10C, thereby fastening the rear supports 10B and 10C in the state in which the opening angle θ is retained. In addition, the relative positions of the adjacent rear supports 10B and 10C in the longitudinal direction are determined by the longitudinal positioning surfaces 242a formed at the left and right ends of the connection support member 240, and the positions of the rear supports 10B and 10C in the lateral direction are also determined by the lateral positioning surfaces 242b. Further, the connection support members 240 are also fastened to the rear of the rear supports 10A and 10B, and the opening angle formed between the rear supports 10A and 10B is set to θ in the same manner.

The display device 211 illustrated in Fig. 17 can be produced using the same production processes in the method of producing the display device 201 illustrated in Figs. 13 to 16. Specifically, the flat connected support member 202 and the flat cover assembly 203 are joined together, and then a sufficient curing time is provided to strongly join the connected support member 202 and the cover assembly 203 together, as illustrated in Fig. 13. Then, an external force is applied so that an opening angle θ2 formed in the forward direction (the direction Y1) between the adjacent rear supports 10A and 10B becomes less than 180, and the opening angle θ1 formed between the rear supports 10B and 10C becomes greater than 180 degrees. Thereafter, connection support members 442 are fastened to the rear of the rear supports 10A and 10B, and connection support members 441 are fastened to the rear of the rear supports 10B and 10C. In the display device 211 illustrated in Fig. 17, both of the angle θ1 and the angle θ2 can be set to greater than 180 degrees.

Alternatively, the opening angle θ formed between the rear supports 10B and 10C can be set to less than 180 degrees, and the opening angle formed between the rear supports 10A and 10B may be left at 180 degrees in the display device 201 illustrated in Fig. 14 or 16. Further, the opening angle θ formed between the rear supports 10B and 10C is set to greater than 180 degrees, and the opening angle θ formed between the rear supports 10A and 10B may be left at 180 degrees in the display device 211 illustrated in Fig. 17. Furthermore, the display device 1 of the first embodiment, in which the two rear supports 10A and 10B are connected, may be produced in a manner such that the opening angle formed between the adjacent rear supports 10A and 10B (along with the cover plate 30 adhered thereto) becomes less than 180 degrees or greater than 180 degrees.

### <Advantages of display devices 1, 101, 201, and 211>

The advantages (effects) of the display devices 1, 101, 201, and 211 of the above embodiments and production methods of the display devices are as follows.

When it is attempted to construct a display device 1 having a display region with a large area, such as an in-vehicle display device or the like, with one rear support, the rear support becomes large, and it is difficult to maintain a high dimensional precision for the rear support and is particularly difficult to maintain flatness. Conversely, the rear supports 10A, 10B, and 10C, each of which is provided to correspond to one display panel, are independently produced in the display devices 1, 101, 201, and 211 of the above embodiments, and the size of each rear support is small in comparison with the large overall area of the display device 1, 101, 201, or 211, and therefore a high level of flatness can be maintained. By connecting the two or more rear supports with a molded resin body 20 or 120, and fastening connection support members 40, 140, 240, 441, or 442 to the rear of the adjacent rear supports across the adjacent rear supports, relative positions of the adjacent rear supports can be determined by the connection support members 40, 140, 240, 441, or 442. Thus, a display device, which has a small dimensional error as a whole, and precisely maintains flatness, can be provided.

In the display device 1, 101, 201, or 211 of the above embodiments, each rear support 10A, 10B, or 10C is formed by die-casting a magnesium alloy, an aluminum alloy, a zinc alloy, or the like. Therefore, it is possible to achieve high dimensional precision and a high level of flatness for each rear support. However, a display device including one metal rear support and multiple display panels has the following problem. If static electricity is discharged from a finger, which approaches the cover plate to operate a capacitive touchscreen, to one of the display panels, the electrostatic discharge affects not only the one of the display panels, but also affects other display panels through transmission of the static electricity via the metal rear support, thereby causing noise in the multiple display panels. Conversely, in the display device 1, 101, 201, or 211 of the present embodiment, separate display panels and touchscreen sensors are independently provided to rear supports, respectively, and an insulating resin connector 21 or 121 is provided between the adjacent rear supports. Therefore, static electricity is unlikely to be transmitted to another rear support and another display panel, and an adverse effect due to the electrostatic discharge, such as image noise, can be minimized.

Fig. 18 is an explanatory view describing a damaged state when an impact is applied from the front of the display device 1 of the first embodiment. If an impact force is applied from the front of the rear support 10A, for example, the resin connector 21 is deformed to absorb the impact (shock). Since the cover plate 30 is a thin plate material, the cover plate 30 can be readily deformed. Moreover, the connection support member 40 is formed of a material having low rigidity or high brittleness compared to the material of the rear supports 10A and 10B so that the connection support members 40 are likely to be deformed or broken corresponding to deformation of the resin connector 21. Therefore, resistance against the external impact can be buffered by the deformation of the resin connector 21 and deformation or breakage of the connection support members 40, thereby securing safety of a driver and passengers when an impact is applied during the traveling of the vehicle.

Fig. 19A illustrates the display device 101 of the second embodiment. The resin connector 121 used for the display device 101 has multiple recesses 121a, and therefore the resin connector 121 is readily deformed as an impact is applied. The connection support member 140 is preferably formed of a material having higher brittleness than the material of the rear supports 10B and 10C. A recess 145 descending from the front surface toward the rear is formed in the connection support member 140. Alternatively, a recess descending from the rear surface toward the front may be formed in the connection support member 140. As an impact force is applied from the front of the display device 101, as illustrated in Fig. 19B, the resin connector 121 having the multiple recesses 121a can be readily deformed, and the connection support member 140 is likely to be broken at the site where the recess 145 is formed. Thus, the impact force from the front can be easily absorbed.

According to the method of producing the display device 201 or 211 of the third embodiment illustrated in Figs. 13 to 17, the resin connector 121 (or the resin connector 21) and the cover plate 30 are deformed so that a display device having an opening angle θ other than 180 degrees in the forward direction can be produced in a simple manner. If production of a display device having an opening angle θ other than 180 degrees in the forward direction is attempted using one rear support for multiple display panels, a rear support having a three-dimensional shape having the opening angle of less than 180 degrees or greater than 180 degrees in the forward direction needs to be formed by die-casting or the like, and therefore a mold to be used becomes complicated, or a production cost increases. If bonding of a cover plate is attempted to a front surface of a rear support that is formed to have an opening angle other than 180 degrees in advance, the cover plate could be detached and lifted from the rear support at the bent portion, or the cover plate could likely be peeled from the front surface of the rear support. Conversely, according to the method of producing the display device 201 or 211 of the third embodiment, the flat cover assembly 3 is bonded to the flat connected support member 202 as illustrated in Fig. 13, and therefore the cover assembly 3 and the connected support member 202 can be cured in the flat state after bonding via the adhesive layer 4, thereby strongly joining the rear supports with the cover plate. Then, the cover plate 30 is bent so that an opening angle θ formed between the adjacent rear supports becomes less than 180 degrees as illustrated in Fig. 14, or an opening angle θ1 becomes greater than 180 degrees as illustrated in Fig. 17, and therefore the cover plate 30 is unlikely to be peeled from the rear supports in the produced display device 201.

### <Display device 301 of fourth embodiment>

The display device of an embodiment of the present disclosure may include a combination of rear supports having different sizes, which can be connected together using a molded resin body. All rear supports may have mutually different sizes. In the connected support member 302 of the display device 301 of the fourth embodiment illustrated in Fig. 20, two rear supports 10A and 10B having the identical structure and identical shape, and a rear support 110 having a different size to that of the rear supports 10A and 10B are connected together with the molded resin body 20. As described above, multiple rear supports having the different shapes and sizes may be connected to constitute the connected support member. However, among the multiple rear supports, at least two rear supports preferably have the identical size and shape as illustrated in Fig. 20. Since two or more rear supports having the identical shape and size are used, a production cost can be reduced by using a common mold for shaping the rear supports or the like.

## Claims

1. A display device, comprising:
rear supports;
a cover plate that is translucent and is fastened to a front of the rear supports;
display panels disposed between the rear supports and the cover plate; and
a resin connector,
wherein the rear supports are connected with one another via the resin connector,
the cover plate covers the front of the rear supports, and is fastened to each of the rear supports, and
the display panels are disposed corresponding to the rear supports, respectively.

2. The display device according to claim 1, further comprising:
a resin frame that is formed continuously along an outer periphery of the rear supports connected with one another via the resin connector, and is formed integrally with the resin connector.

3. The display device according to claim 1 or 2,
wherein, among the rear supports, two or more rear supports have an identical shape and an identical size.

4. The display device according to one of claims 1 to 3,
wherein the resin connector has a recess that descends forward or rearward.

5. The display device according to one of claims 1 to 4, further comprising:
a connection support member that is fastened to a rear of each pair of the rear supports adjacent to each other across the resin connector.

6. The display device according to claim 5,
wherein the connection support member is configured to determine relative positions, in a longitudinal direction, of each pair of the rear supports adjacent to each other.

7. The display device according to claim 5 or 6,
wherein the connection support member includes a recess that descends forward or rearward.

8. The display device according to one of claims 1 to 7,
wherein front surfaces of the rear supports of each pair of the rear supports adjacent to each other, which are connected via the resin connector, form an angle other than 180 degrees between the front surfaces.

9. The display device according to one of claims 1 to 8,
wherein the display panels are liquid crystal display panels, and backlight units are retained in the rear supports, respectively.

10. A method of producing a display device, which includes rear supports, a cover plate that is translucent and fastened to a front of the rear supports, and display panels disposed between the rear supports and the cover plate, the method comprising:
(a) connecting the rear supports with one another via a resin connector; and
(b) covering, with the cover plate, the front of the rear supports connected with one another via the resin connector, and fastening the cover plate to each of the rear supports,
wherein the display panels are disposed corresponding to the rear supports, respectively.

11. The method according to claim 10, further comprising:
forming a resin frame integrally with the resin connector, the resin frame being continuous along an outer periphery of the rear supports connected with one another via the resin connector.

12. The method according to claim 11,
wherein the resin connector and the resin frame are integrally formed by insert molding.

13. The method according to one of claims 10 to 12, further comprising:
fastening a connection support member to a rear of each pair of the rear supports adjacent to each other across the resin connector, and relatively positioning, in a longitudinal direction, each pair of the rear supports adjacent to each other using the connection support member.

14. A method of producing a display device, which includes rear supports, a cover plate that is translucent and fastened to a front of the rear supports, and display panels disposed between the rear supports and the cover plate, the method comprising:
(a) connecting rear supports with one another via a resin connector;
(b) covering, with the cover plate, the front of the rear supports connected with one another via the resin connector, and fastening the cover plate to each of the rear supports;
(c) after (b), deforming the resin connector and the cover plate so that front surfaces of respective rear supports in each pair of the rear supports adjacent to each other, which are connected via the resin connector, forms an angle other than 180 degrees between the front surfaces; and
(d) fastening a connection support member to the rear of each pair of the rear supports adjacent to each other across the resin connector to fix relative positions of each pair of the rear supports adjacent to each other.

15. The method according to claim 14, further comprising:
forming a resin frame integrally with the resin connector, the resin frame being continuous along an outer periphery of the rear supports connected with one another via the resin connector.
